# EUROPEAN PATENT SPECIFICATION

(11) **EP 4 336 563 B1**
(45) Date of publication and mention of the grant of the patent: **29.04.2026**
(21) Application number: 22944072.2
(22) Date of filing: 07.09.2022
(51) Int. Cl.: H10D 84/82, H10D 84/05, H10D 30/47, H10D 30/01, H10D 64/27, H10D 62/85, H10D 62/17

(54) **GAN-BASED HEMT STRUCTURE HAVING MULTIPLE THRESHOLD VOLTAGES, AND PREPARATION METHOD THEREFOR AND APPLICATION THEREOF**
GAN-BASIERTE HEMT-STRUKTUR MIT MEHREREN SCHWELLENSPANNUNGEN UND HERSTELLUNGSVERFAHREN DAFÜR UND ANWENDUNG DAVON
STRUCTURE HEMT À BASE DE GAN AYANT DE MULTIPLES TENSIONS DE SEUIL, SON PROCÉDÉ DE PRÉPARATION ET SON APPLICATION

(30) Priority: 07.07.2022 CN 202210808044
(43) Date of publication of application: 13.03.2024
(73) Proprietor: Guangdong Institute of Semiconductor Micro-Nano Manufacturing Technology, Foshan, Guangdong 528225 (CN); Suzhou Institute of Nano-Tech and Nano-Bionics (SINANO), Chinese Academy of Sciences, Suzhou, Jiangsu 215123 (CN)
(72) Inventor: ZHONG, Yaozong, Foshan, Guangdong 528225 (CN); SUN, Qian, Foshan, Guangdong 528225 (CN); GAO, Hongwei, Foshan, Guangdong 528225 (CN); GUO, Xiaolu, Foshan, Guangdong 528225 (CN); CHEN, Xin, Foshan, Guangdong 528225 (CN); YANG, Yong, Foshan, Guangdong 528225 (CN); YANG, Hui, Foshan, Guangdong 528225 (CN)
(74) Representative: Bayramoglu et al.
(86) International application number: PCT/CN2022/117566
(87) International publication number: WO 2024/007443

(56) References cited:
- CN-A- 107 210 323
- CN-A- 112 185 959
- CN-A- 112 599 523
- CN-A- 114 038 909
- US-A1- 2015 162 424
- US-A1- 2015 243 775
- US-A1- 2016 351 564
- US-A1- 2017 125 572
- US-A1- 2019 109 222
- US-A1- 2022 130 989

## Description

### TECHNICAL FIELD

The application relates to a High Electron Mobility Transistor (HEMT) device structure, and specifically, to a GaN-based HEMT structure having a multi-threshold voltage, and a preparation method and an application therefor, which belongs to the technical field of semiconductors.

### BACKGROUND

Group III nitride semiconductors represented by GaN are called the third-generation semiconductors, which have the advantages of large band gaps, good chemical stability and high breakdown voltage. In addition, GaN-based HEMTs made of heterojunctions such as AlGaN/GaN have the advantages of high electron concentration and mobility, and have excellent performance in terms of high frequency, high withstand voltage, low on-resistance. The GaN-based HEMTs may be used as core devices of various power conversion systems and radio-frequency power amplifier systems, and have broad prospects in application fields such as consumer electronics, industrial electronics, and automotive electronics.

In the fields such as power electronics and radio-frequency electronics, in order to achieve certain specific functions such as signal noise reduction and operational amplification, a logic functional circuit generally needs to be integrated in a chip. In a modern large-scale integrated circuit based on silicon, a basic unit of a logic circuit is formed by a N-channel Metal-Oxide-Semiconductor Field Effect Transistor (N-MOSFET) and a P-channel Metal-Oxide-Semiconductor Field Effect Transistor (P-MOSFET), that is, a Complementary Metal-Oxide-Semiconductor (C-MOS) circuit (which is a complementary logic circuit), having the advantages of low power consumption and high integration. The N-MOSFET is a field effect transistor that is prepared by inverting electrons as conductive channels on a p-type silicon material; and the P-MOSFET is a field effect transistor that is prepared by inverting holes as conductive channels on a n-type silicon material. However, since there are many defective states in a GaN-based material, non-doped GaN often shows weak n-type, and due to incomplete ionization properties of acceptor Mg impurities, the p-type material needs to be doped with high-concentration Mg. In addition, the bulk mobility of holes in the GaN is very low, which is generally at 1-10 cm2/(V·s). Therefore, due to a large band gap of the GaN material and lack of a reliable gate dielectric material, it is difficult to achieve a solution of using a semiconductor to perform inversion or strong inversion so as to generate electrons or holes, and in particular, it is almost impossible to generate holes with high mobility.

At present, a solution for implementing an N-MOSFET in a GaN system mainly includes: using, as a conductive channel, Two-dimensional Electron Gas (2DEG) induced by an AlGaN/GaN heterojunction polarization effect, and realizing an enhanced n-FET with a threshold voltage being positive by using technical solutions such as a groove gate and a p-type gate, so as to achieve the properties of the N-MOSFET of turning on at high level and turning off at low level. It is noted that a FET with a positive threshold voltage is denoted as "enhanced" in the present description, while it is claimed as "enhanced-mode" and frequently called "enhancement-mode" elsewhere. A solution for implementing a P-MOSFET mainly includes: using, as a conductive channel, two-dimensional hole gas induced by a p-GaN/AlGaN heterojunction polarization effect, and realizing an enhanced p-FET with a threshold voltage being negative by using gate technologies such as the groove gate and an ion-implanted gate, so as to achieve the properties of a P-MOS transistor of turning on at high level and turning off at low level. Then, the n-FET and the p-FET are connected in series to construct a complementary logic circuit unit, so as to finally achieve related functional circuit design and manufacturing. However, there are still many technical difficulties in preparation of GaN-based n-FET and p-FET complementary logic circuits (Logic 0/1).

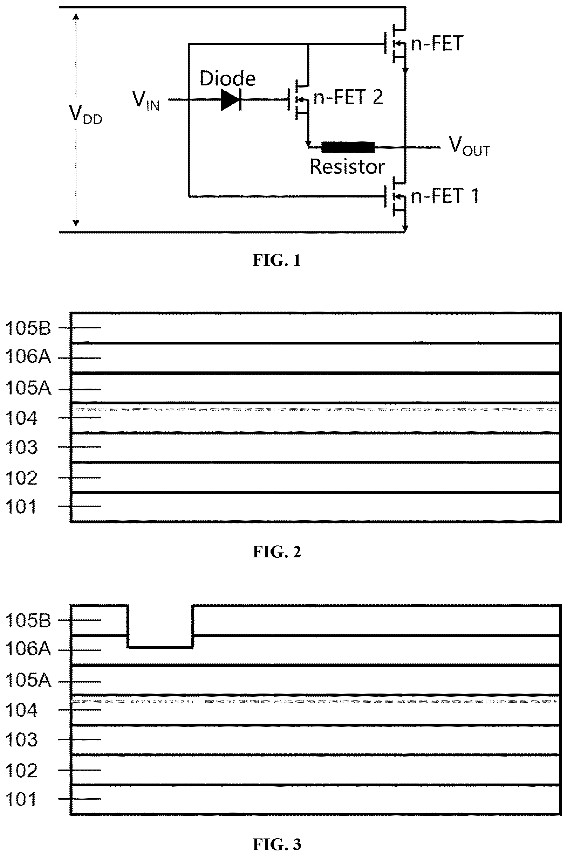

Currently, in a silicon semiconductor technology, there is a logic circuit based on low and high threshold voltage devices (Logic 1/2), referring to FIG. 1. Enhanced transistors (a n-FET 1 and a n-FET 2) with different threshold voltages are used to manufacture a logic circuit functional unit, operation processing of signals is implemented by using switch state differences of the transistors at different gate voltages. Such circuit design does not need the GaN-based p-FET, such that the logic circuit may have the ability to perform fast operations. However, high and low threshold logic circuits need to stably, uniformly implement devices with at least two different threshold voltages in the same wafer, or even a very small area.

To sum up, the performance requirements of an existing GaN-based complementary logic circuit technology for GaN-based p-FETs and the technical requirements of existing high and low threshold logic circuits pose a great challenge for the manufacturing of current GaN-based HEMT devices. Details are as follows.

First, the GaN-based p-FET in the complementary logic circuit technology generally uses bulk holes in p-type GaN or two-dimensional hole gas at a p-GaN/AlGaN interface, which has a very low mobility of around 10 cm²/(V·s) at room temperature and up to 50 cm²/(V · s), and has a huge difference from the AlGaN/GaN-induced 2DEG that typically has a mobility of 1500 cm²/(V˙s). However, the ultimate operational speed of a logic operational circuit is strongly associated with the mobility of carriers in a semiconductor material; and if the mobility of the carriers is higher, the ultimate operational speed of the circuit is faster. Therefore, the ultimate operational speed of the logic circuit formed by the GaN-based p-FET and n-FET is limited to the mobility of the two-dimensional hole gas, such that it is difficult to take advantage of a GaN material system.

Second, the GaN-based p-FET in the complementary logic circuit technology requires a high-quality p-GaN ohmic contact. However, the current preparation of the p-GaN ohmic contact requires a p-GaN surface layer to be heavily doped with Mg to above 10²⁰ cm⁻³ and also requires use of metals with high work functions, such as Ni, Pd, etc. Contact resistivity is also generally above 10⁻⁴ Ω · cm² when a preparation condition is relatively harsh, and higher contact resistivity leads to larger power losses. In addition, due to preparation processes, the thermal stability of the p-GaN ohmic contact is relatively poor, and unsuitable for harsh operating environments.

Third, a p-FET gate in the complementary logic circuit technology is mostly prepared by processes such as etching and ion implantation, resulting in problems of uniformity and reliability. When a GaN dry etching method is used to reduce a p-FET gate area or ion implantation is used to perform acceptor compensation on the p-GaN, it is difficult to avoid lattice damage and surface staining to a GaN layer, introducing a gate interface state, causing device performance deterioration problems such as threshold voltage drift and large leakage, and the performance of the prepared p-FET is difficult to meet the requirements of logic operations.

Fourth, the high and low threshold logic circuit technology requires to implement enhance-mode devices (for example, devices with a threshold voltage>1 V and >2 V) with high and low threshold voltages on the same wafer, and requires extremely high uniformity and reliability. For GaN-based devices, there is no perfect solution. US2015/243775A1 describes a semiconductor device. In one embodiment, the device includes a Group-III nitride channel layer and a Group-III nitride barrier layer on the Group-III nitride channel layer, wherein the Group-III nitride barrier layer includes a first portion and a second portion, the first portion having a thickness less than the second portion. A p-doped Group-III nitride gate layer section is arranged at least on the first portion of the Group-III nitride barrier layer and a gate contact formed on the p-doped Group-III nitride gate layer. US2019/109222A1 discloses a semiconductor device. The semiconductor device includes a plurality of unit cell transistors on a common semiconductor structure, the unit cell transistors electrically connected in parallel, and each unit cell transistor including a respective gate finger. Respective threshold voltages of first and second of the unit cell transistors differ by at least 0.1 volts and/or threshold voltages of first and second segments of a third of the unit cell transistors differ by at least 0.1 volts. US2016/351564A1 discloses a multi-layer semiconductor structure for use in III-Nitride semiconductor devices. The semiconductor structure includes a channel layer, a band-offset layer having a wider bandgap than the channel layer, an optional spacer layer having a narrower bandgap than the band-offset layer, and a cap layer comprising at least two sublayers. Each sublayer is selectively etchable with respect to sublayers immediately below and above, each sublayer comprises a III-N material AlxInyGazN in which 0 ≦ x ≦ 1, 0 ≦ y ≦ 1, and 0 ≦ z ≦ 1, at least one sublayer has a non-zero Ga content, and a sublayer immediately above the spacer layer has a wider bandgap than the spacer layer. Also described are methods for fabricating such semiconductor structures, with gate and/or ohmic recesses formed by selectively removing adjacent layers or sublayers. In one embodiment, a first transistor is gate-recessed and includes a gate with a gate recess depth through the entire cap layer, and a second transistor has a planer gate on the cap layer. In some embodiments, both transistors are enhancement-mode transistors.

US2022/130989A1 discloses apparatus and circuits including transistors with different polarizations and methods of fabricating the same. In one example, a semiconductor structure is disclosed. The semiconductor structure includes: a substrate; an active layer that is formed over the substrate and comprises a first active portion and a second active portion; a first transistor comprising a first source region, a first drain region, and a first gate structure formed over the first active portion and between the first source region and the first drain region; and a second transistor comprising a second source region, a second drain region, and a second gate structure formed over the second active portion and between the second source region and the second drain region, wherein the first active portion has a material composition different from that of the second active portion.

### SUMMARY

The present application is mainly intended to provide a GaN-based HEMT structure having a multi-threshold voltage, and a preparation method therefor, to overcome deficiencies in the related art.

In order to implement the foregoing objective of the present application, the technical solutions adopted by the present invention are as presented in the appended claims 1-2.

Compared with the related art, firstly, according to the present application, an enhanced GaN-based HEMT structure with more than two threshold voltages can be implemented on the same wafer, and a preparation process is compatible with a preparation process of conventional group III-V semiconductor devices, such that the HEMT structure is suitable for industrial production; secondly, the barrier layer of the GaN-based HEMT may be an AlGaN/GaN/AlGaN composite structure, and an introduced GaN insertion layer may be used as a sacrificial layer for etching and thermal decomposition in the first gate area, such that the thickness of the AlGaN barrier layer in the gate area can be guaranteed, etching damage can be effectively removed, and a good guarantee is formed for the uniformity of the threshold voltage and the reliability of devices; furthermore, compared with a circuit in which a depleted/enhanced GaN HEMT forms a cooperation, the circuit in which the enhanced GaN HEMT with two threshold voltages implemented in the present application form a cooperation has lower power consumption and higher safety; and finally, the two enhanced GaN HEMTs implemented in the present application both use high-mobility 2DEG as the conductive channels, which have the capabilities of rapid on-off, and the logic circuit manufactured through cooperation has a faster calculation speed and a stronger anti-interference capability. Therefore, the present application can well meet application requirements of high and low threshold logic circuits.

### BRIEF DESCRIPTION OF THE DRAWINGS

In order to describe the technical solutions in embodiments of the present application more clearly, the drawings required to be used in the embodiments will be simply introduced below. It is apparent that the drawings in the following descriptions are only some embodiments of the present application. Those of ordinary skill in the art may further obtain other drawings according to these drawings without creative work.
FIG. 1 is a schematic diagram of a logic unit consisting of an HEMT with a multi-threshold voltage in the related art.
FIG. 2 is a schematic diagram of an epitaxial structure of a GaN-based HEMT device according to Embodiment 1.
FIG. 3 is a schematic diagram of a groove structure manufactured in a first gate area of the epitaxial structure shown in FIG. 2.
FIG. 4 is a schematic diagram of a secondary epitaxial P-type layer on the epitaxial structure shown in FIG. 3.
FIG. 5 is a schematic diagram of a P-type gate manufactured on a device structure shown in FIG. 4.
FIG. 6 is a schematic structural diagram of a GaN-based HEMT device according to Embodiment 1.
FIG. 7 is a schematic structural diagram of a GaN-based HEMT device according to Embodiment 2 (not constituting a part of present invention).
FIG. 8 is a schematic structural diagram of a GaN-based HEMT device according to Embodiment 3 (not constituting a part of present invention).
FIG. 9 is a schematic structural diagram of a GaN-based HEMT device according to Embodiment 4 (not constituting a part of present invention).
FIG. 10 is a schematic structural diagram of a GaN-based HEMT device according to Embodiment 5 (not constituting a part of present invention).

### DETAILED DESCRIPTION OF THE EMBODIMENTS

A GaN-based HEMT structure having a multi-threshold voltage provided in some embodiments of the present application includes a channel layer and a barrier layer. A 2DEG is formed between the channel layer and the barrier layer; the barrier layer is at least provided with a first source area, a second source area, a first gate area, a second gate area, a first drain area, and a second drain area; the first source area, the first gate area, and the first drain area cooperate with each other, so as to form a first HEMT unit, and the first HEMT unit has a first threshold voltage; the second source area, the second gate area, and the second drain area cooperate with each other, so as to form a second HEMT unit, and the second HEMT unit has a second threshold voltage; and the thickness of the barrier layer in the first gate area is less than that in the second gate area, so as to enable the first threshold voltage to be higher than the second threshold voltage.

The HEMT structure further includes a P-type layer. The P-type layer is disposed on a plurality of gate areas of the barrier layer, and is configured to reduce or exhaust the 2DEG under the plurality of gate areas of the barrier layer.

Further, a groove structure is formed in one gate area of the barrier layer; and the P-type layer distributed on the gate area is at least partially filled in the groove structure.

Compared with an existing GaN-based p-FET, the HEMT structure of the present application is a n-FET, and implements different threshold voltages by epitaxially growing a p-type cap layer on the groove of the barrier layer with different thicknesses. Therefore, there is no need to face the difficulty of p-GaN ohmic contact preparation of the p-FET, that is: heavy doping of a p-GaN surface layer, metals using high work functions, and harsh process conditions; and there is also no need to face the problems of high defective state concentration and low hole mobility in a p-GaN material.

The barrier layer includes two AlGaN barrier sub-layers and a GaN insertion layer, and the insertion layer is distributed between the two barrier sub-layers.

When the barrier layer is etched to form a gate groove, the GaN insertion layer is used as a sacrificial layer for etching and thermal decomposition, so as to effectively remove lattice damage and surface staining, and thermal decomposition is automatically stopped at the AlGaN barrier layer below, such that device performance deterioration problems such as threshold voltage drift and large leakage caused by a gate interface state introduced by etching may be avoided, and the consistency of the thickness of the first gate area or the first gate area and the second gate area is guaranteed, thereby improving the uniformity of the device threshold voltages.

In addition, the preparation method may further include other device processing processes known in the art. For example, a surface passivation layer is manufactured on a device structure; a gate, a source, and a drain are further manufactured after a dielectric layer is deposited; and metals are deposited on electrodes to prepare a field-plate structure, so as to form a final GaN-based HEMT device.

In the present application, the GaN-based HEMT structure includes an AlGaN/GaN heterojunction, and a method for performing secondary epitaxy on a p-GaN or AlGaN/p-GaN layer on the AlGaN barrier layer with and without grooves or a GaN channel layer is used; and then two p-GaN gates are prepared through patterning, so as to implement an enhanced device with high and low threshold voltages on the same wafer.

Specifically, for a gate groove area of the AlGaN barrier layer, the thickness of the barrier layer in the area is relatively small, such that the concentration of the 2DEG induced by the AlGaN/GaN heterojunction is relatively low; and after the secondary epitaxy of p-GaN or AlGaN/p-GaN, the 2DEG under the gate is easily exhausted, and an energy band is highly lifted, so as to form an HEMT unit with a high threshold voltage. For a gate area of the AlGaN barrier layer that has no grooves, the thickness of the barrier layer in the area is relatively large, and an HEMT unit with a low threshold voltage is formed at a p-GaN gate prepared through secondary epitaxy as the barrier layer is thick. The thicknesses of the AlGaN barrier layers of the two HEMT units are controlled by processing devices such as the high-accuracy MOCVD, such that the uniformity of the threshold voltages is guaranteed.

The enhanced GaN-based HEMT structure with more than two threshold voltages can be implemented on the same wafer according to a process that is not claimed, and is compatible in preparation process with the conventional group III-V semiconductor devices, such that the HEMT structure is suitable for industrial production, and can effectively guaranteed the uniformity of the threshold voltages of the GaN-based HEMT structure and the reliability of the devices.

In particular, since an AlGaN/GaN/AlGaN composite structure is used as the barrier layer of the GaN-based HEMT, the introduced GaN insertion layer may be used as a sacrificial layer for etching and thermal decomposition in the first gate area, so as to guaranteed the thickness of the AlGaN barrier layer in the gate area and effectively remove etching damage, such that the uniformity of the threshold voltages of the devices and the reliability of the devices are effectively guaranteed.

Some embodiments of the present application further provide a high and low threshold logic circuit, which includes the GaN-based HEMT structure having a multi-threshold voltage. Compared with a circuit in which a depleted/enhanced GaN HEMT forms a cooperation, the circuit in which the enhanced GaN HEMT with various threshold voltages forms a cooperation has lower power consumption and higher safety. In addition, the various enhanced GaN HEMTs all use high-mobility 2DEG as the conductive channels, which have the capabilities of rapid on-off, and the logic circuit manufactured through cooperation has a faster calculation speed and a stronger anti-interference capability.

In brief, according to the present application, high-uniformity high and low threshold voltage enhanced HEMTs may be implemented on a GaN-based wafer, and a basic device requirement of a 1/2 logic circuit is met. In addition, compared with an existing p-FET, the GaN-based HEMT structure of the present application has higher reliability. Compared with an existing complementary logic circuit, the logic circuit implemented by the GaN-based HEMT structure of the present application uses the high-mobility 2DEG as the conductive channels, such that the logic circuit has the characteristics of rapid on-off speed and high integration.

The technical solutions of the present application will be described in more detail below in combination with the drawings and several embodiments, but it should be understood that the following embodiments are intended only to explain and illustrate the technical solutions, but do not limit the scope of the present application. Unless otherwise specified, the various raw materials, reaction devices, testing devices and methods used in the following embodiments are known in the art.

### Embodiment 1

Referring to FIG. 2 to FIG. 6, a method for preparing a GaN-based HEMT device having a multi-threshold voltage provided in this embodiment includes the following steps.

At S1, an MOCVD method is used; an AlN/AlGaN transition layer 102 with the thickness being about 300 nm, a C-doped Al_{0.07}Ga_{0.93}N high resistance layer 103 with the thickness being about 4 µm, an unintentional doped GaN layer 104 with the thickness being about 150 nm, a first AlGaN barrier sub-layer 105A with the thickness being about 12 nm, a GaN insertion layer 106A with the thickness being about 4 nm, and a second AlGaN barrier sub-layer 105B with the thickness being about 4 nm are sequentially grown on a Si<111> substrate 101, as shown in FIG. 2. The first AlGaN barrier sub-layer 105A and the second AlGaN barrier sub-layer 105B form a barrier layer.

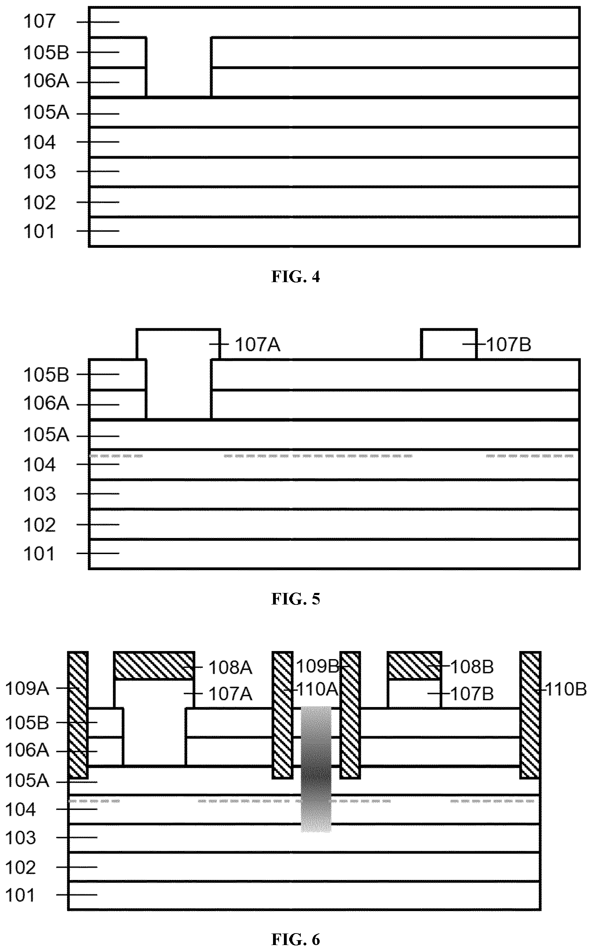

At S2, photoresist is used as a mask; and after photoetching patterning, an ICP etching method is used to remove a first gate area of the second AlGaN barrier sub-layer 105B by about 6 nm in a thickness direction, so as to form a groove structure, as shown in FIG. 3. After wet surface treatment and MOCVD high temperature thermal decomposition treatment, the groove structure is ended at the surface of the first AlGaN barrier sub-layer 105A; and then secondary epitaxy is performed on a p-type GaN layer of which thickness is about 80 nm and a Mg doping concentration is 2-5×10¹⁹/cm³, as shown in FIG. 4.

At S3, the photoresist is used as the mask; and after photoetching patterning, a dry etching method is used to remove the p-GaN layer in a non-gate area, and etching is stopped at the surface of the first AlGaN barrier sub-layer 105A, so as to prepare a first p-GaN layer 107A (which may also be named as a first P-type gate) in the first gate area, and prepare a second p-GaN layer 107B (which may also be named as a second P-type gate) in a second gate area of the second AlGaN barrier sub-layer 105B, as shown in FIG. 5.

At S4, organic cleaning methods such as acetone are used to remove the photoresist, and the heights of the two P-type gates are about 80 nm through testing. Then hydrofluoric acid (HF) is used to remove an oxide layer on the surface of the barrier layer, and rapid annealing is performed at an atmosphere of 500oC and N₂, so as to recover 2DEG at an AlGaN/GaN heterojunction. Then, Ti/Au is deposited on the two P-type gates; a first schottky gate contact metal 108A and a second schottky gate contact metal 108B are prepared after annealing; Ti/Al/Ti/Au is respectively deposited in each source area and drain area of the barrier layer, so as to respectively form a first source contact metal 109A, a second source contact metal 109B, a first drain contact metal 110A, and a second drain contact metal 110B; and an ohmic contact is prepared after annealing. Then, a transistor unit A with a high threshold voltage is formed through the cooperation of the first schottky gate contact metal 108A, the first source contact metal 109A, and the first drain contact metal 110A; and a transistor unit B with a low threshold voltage is formed through the cooperation of the second schottky gate contact metal 108B, the second source contact metal 109B, and the second drain contact metal 110B.

The structure of a GaN-based HEMT device finally prepared in this embodiment is shown in FIG. 6.

I-V methods are used to perform gate transfer characteristic testing on the GaN-based HEMT device, so as to obtain the mean value of threshold voltages of the transistor unit A to be about 2.1 V, and the mean value of threshold voltages of the transistor unit B to be about 1.3 V. A test result verifies that, according to the solution of this embodiment, a p-type gate enhanced HEMT with high and low threshold voltages may be prepared on the same wafer.

### Embodiment 2 (not constituting a part of present invention)

A method for preparing a GaN-based HEMT device having a multi-threshold voltage provided in this embodiment includes the following steps.

At S1, referring to S1 in Embodiment 1, an AlN/AlGaN transition layer 202, a C-doped Al_{0.07}Ga_{0.93}N high resistance layer 203, an unintentional doped GaN layer 204, and an AlGaN barrier layer 205A with the thickness being about 18-25 nm are sequentially grown on a substrate 201 by using the MOCVD method.

At S2, referring to S2 in Embodiment 1, photoresist is used as a mask; and after photoetching patterning, an ICP etching method is used to remove a portion (for example, about 6 nm) from a first gate area of the AlGaN barrier layer 205A in a thickness direction, so as to form a groove structure. After wet surface treatment and MOCVD high temperature thermal decomposition treatment, the groove structure is ended at a certain depth (8-20 nm from a groove bottom to a channel layer) in the AlGaN barrier layer 205A, and then secondary epitaxy is performed on a p-type GaN layer or a p-type AlGaN layer (referred to as p-type cap layer).

At S3, referring to S3 in Embodiment 1, the photoresist is used as the mask; and after photoetching patterning, a dry etching method is used to remove the p-type cap layer in a non-gate area, and etching is stopped at the surface of the AlGaN barrier layer 205A, so as to prepare a first p-type cap layer 207A (which may also be named as a first P-type gate) in the first gate area, and prepare a second p-type cap layer 207B (which may also be named as a second P-type gate) in a second gate area of the AlGaN barrier layer 205A.

At S4, referring to S4 in Embodiment 1, organic cleaning methods such as acetone are used to remove the photoresist, then hydrofluoric acid (HF) is used to remove an oxide layer on the surface of the barrier layer, and rapid annealing is then performed, so as to recover 2DEG at an AlGaN/GaN heterojunction. Then, Ti/Au is deposited on the two P-type gates; a first schottky gate contact metal 208A and a second schottky gate contact metal 208B are prepared after annealing; Ti/Al/Ti/Au is respectively deposited in each source area and drain area of the barrier layer, so as to respectively form a first source contact metal 209A, a second source contact metal 209B, a first drain contact metal 210A, and a second drain contact metal 210B; and an ohmic contact is prepared after annealing. Then, a transistor unit A with a high threshold voltage is formed through the cooperation of the first schottky gate contact metal 208A, the first source contact metal 209A, and the first drain contact metal 210A; and a transistor unit B with a low threshold voltage is formed through the cooperation of the second schottky gate contact metal 208B, the second source contact metal 209B, and the second drain contact metal 210B.

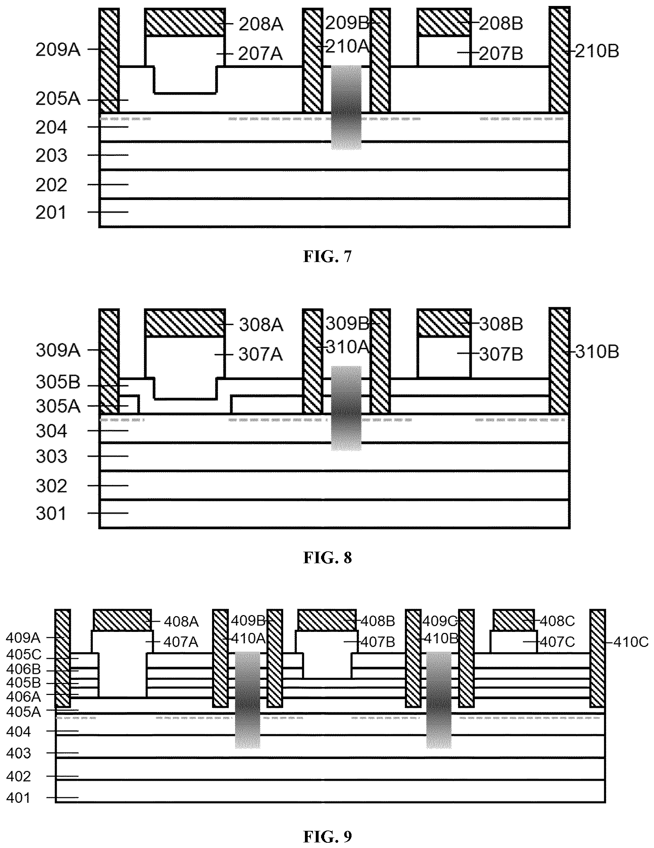

The structure of a GaN-based HEMT device finally prepared in this embodiment is shown in FIG. 7.

Gate transfer characteristic testing is performed on the GaN-based HEMT device in this embodiment, so as to obtain the mean value of threshold voltages of the transistor unit A to be about 2.3V, and the mean value of threshold voltages of the transistor unit B to be about 1.1V.

### Embodiment 3 (not constituting a part of present invention)

A method for preparing a GaN-based HEMT device having a multi-threshold voltage provided in this embodiment includes the following steps.

At S1, referring to S1 in Embodiment 1, an AlN/AlGaN transition layer 302, a C-doped Al_{0.07}Ga_{0.93}N high resistance layer 303, an unintentional doped GaN layer 304, and a first AlGaN barrier sub-layer 305A with the thickness being about 2-10 nm are sequentially grown on a substrate 301 by using the MOCVD method. Then a left-side gate area of the first AlGaN barrier sub-layer 305A is completely removed by means of patterning etching; then secondary epitaxy is performed on a GaN layer with the thickness being about 0-10 nm, an AlGaN layer with the thickness being about 5-15 nm, and a p-(Al)GaN layer with the thickness being about 70 nm, so as to form a laminated structure 305B (preferably, the thickness of the GaN layer is about 5nm, and the thickness of the AlGaN layer is about 10nm).

At S2, referring to S2-S3 in Embodiment 1, a first p-type layer 307A (which may also be named as a first P-type gate) is prepared in a first gate area of the laminated structure 305B, and a second p-type layer 307B (which may also be named as a second P-type gate) is prepared in a second gate area of the laminated structure 305B.

At S3, referring to S4 in Embodiment 1, a first schottky gate contact metal 308A, a second schottky gate contact metal 308B, a first source contact metal 309A, a second source contact metal 309B, a first drain contact metal 310A, and a second drain contact metal 310B are respectively manufactured. Then, a transistor unit A with a high threshold voltage is formed through the cooperation of the first schottky gate contact metal 308A, the first source contact metal 309A, and the first drain contact metal 310A; and a transistor unit B with a low threshold voltage is formed through the cooperation of the second schottky gate contact metal 308B, the second source contact metal 309B, and the second drain contact metal 310B.

The structure of a GaN-based HEMT device finally prepared in this embodiment is shown in FIG. 8.

Gate transfer characteristic testing is performed on the GaN-based HEMT device in this embodiment, so as to obtain the mean value of threshold voltages of the transistor unit A to be about 2.3V, and the mean value of threshold voltages of the transistor unit B to be about 1.3V.

### Embodiment 4 (not constituting a part of present invention)

A method for preparing a GaN-based HEMT device having a multi-threshold voltage provided in this embodiment includes the following steps.

At S1, referring to S1 in Embodiment 1, an AlN/AlGaN transition layer 402, a C-doped Al_{0.07}Ga_{0.93}N high resistance layer 403, an unintentional doped GaN layer 404, a first AlGaN barrier sub-layer 405A, a first GaN insertion layer 406A, a second AlGaN barrier sub-layer 405B, a second GaN insertion layer 406B, and a third AlGaN barrier sub-layer 405C are sequentially grown on a substrate 401 by using the MOCVD method.

At S2, referring to S2 in Embodiment 1, photoresist is used as a mask; after photoetching patterning, an ICP etching method is used to remove a part of a first gate area and a second gate area of the AlGaN barrier layer in a thickness direction, so as to respectively form a first groove structure and a second groove structure; a groove bottom surface of the first groove structure is located on the surface of the first AlGaN barrier sub-layer 405A, and a groove bottom surface of the second groove structure is located on the surface of the second AlGaN barrier sub-layer 405B; and a third gate area of the AlGaN barrier layer is not etched.

At S3, secondary epitaxy is performed on a GaN layer with the thickness being about 0-10 nm, an AlGaN layer with the thickness being about 0-10 nm, and a p-(Al)GaN layer with the thickness being about 70 nm on the AlGaN barrier layer, so as to form a laminated structure (which may also be considered as a P-type layer). Preferably, the thickness of the GaN layer in the laminated structure is about 5nm, and the thickness of the AlGaN layer is about 5nm.

At S4, referring to S3 in Embodiment 1, a first p-type layer 407A, a second p-type layer 407B, and a third p-type layer 407C are respectively prepared in the first gate area, the second gate area, and the third gate area.

At S5, referring to S4 in Embodiment 1, a first schottky gate contact metal 408A, a second schottky gate contact metal 408B, a third schottky gate contact metal 408C, a first source contact metal 409A, a second source contact metal 409B, a third source contact metal 409C, a first drain contact metal 310A, a second drain contact metal 310B, and a third drain contact metal 310C are respectively manufactured. Then, a transistor unit A is formed through the cooperation of the first schottky gate contact metal 308A, the first source contact metal 309A, and the first drain contact metal 310A; a transistor unit B is formed through the cooperation of the second schottky gate contact metal 308B, the second source contact metal 309B, and the second drain contact metal 310B; and a transistor unit C is formed through the cooperation of the third schottky gate contact metal 308C, the third source contact metal 309C, and the third drain contact metal 310C.

The structure of a GaN-based HEMT device finally prepared in this embodiment is shown in FIG. 9.

Gate transfer characteristic testing is performed on the GaN-based HEMT device in this embodiment, so as to obtain the mean value of threshold voltages of the transistor unit A to be about 2.4V, the mean value of threshold voltages of the transistor unit B to be about 1.3V, and the mean value of threshold voltages of the transistor unit C to be about -2.0V.

### Embodiment 5 (not constituting a part of present invention)

A method for preparing a GaN-based HEMT device having a multi-threshold voltage provided in this embodiment includes the following steps.

At S1, referring to S1 in Embodiment 1, an AlN/AlGaN transition layer 502, a high resistance (Al)GaN withstand voltage layer 503, an (Al)GaN conductive channel layer 504, and an AlGaN barrier layer 505 are sequentially grown on a substrate 501 by using the MOCVD method.

At S2, referring to S2 in Embodiment 1, photoresist is used as a mask; after photoetching patterning, an ICP etching method is used to remove a first gate area of the AlGaN barrier layer 505 in a thickness direction, so as to form a groove structure, and the groove structure is ended at the surface of the (Al)GaN conductive channel layer 504; and a second gate area of the AlGaN barrier layer 505 is not etched.

At S3, an insulating gate dielectric layer 506 (with the thickness being about 1-20 nm) such as aluminum nitride is deposited on the surface of the AlGaN barrier layer 505; then referring to S4 in Embodiment 1, a first schottky gate contact metal 508A, a second schottky gate contact metal 508B, a first source contact metal 509A, a second source contact metal 509B, a first drain contact metal 510A, and a second drain contact metal 510B are respectively manufactured. The first schottky gate contact metal and the second schottky gate contact metal preferably use metals with high work functions, such as Ni and Pd. Then, a transistor unit A with a high threshold voltage is formed through the cooperation of the first schottky gate contact metal 508A, the first source contact metal 509A, and the first drain contact metal 510A; and a transistor unit B with a low threshold voltage is formed through the cooperation of the second schottky gate contact metal 508B, the second source contact metal 509B, and the second drain contact metal 510B.

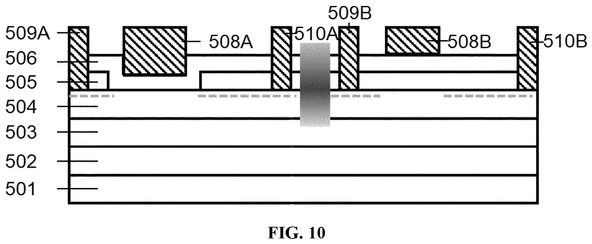

The structure of a GaN-based HEMT device finally prepared in this embodiment is shown in FIG. 10.

According to the above embodiments of the present application, wafer-level preparation of high and low threshold voltage devices is realized by accurately controlling the thickness of the barrier layer or the dielectric layer in the gate area of the device; and the prepared multi-threshold voltage HEMT is high in integrate, high in carrier mobility, and desirable in uniformity of the threshold voltages, such that the HEMT may be used for functional circuits based on Logic 1/2.

## Claims

1. A GaN-based High Electron Mobility Transistor, HEMT, structure having a multi-threshold voltage, comprising a Si<111> substrate (101), an AlN/AlGaN transition layer (102) with a thickness of 300 nm, a C-doped Al_{0.07}Ga_{0.93}N high resistance layer (103) with a thickness of 4 µm, an unintentional doped GaN channel layer (104) with a thickness of 150 nm, a first AlGaN barrier sub-layer (105A) with a thickness of 12 nm, a GaN insertion layer (106A) with a thickness of 4 nm, and a second AlGaN barrier sub-layer (105B) with a thickness of 4 nm, wherein the AlN/AlGaN transition layer (102), the C-doped Al_{0.07}Ga_{0.93}N high resistance layer (103), the unintentional doped GaN channel layer (104), the first AlGaN barrier sub-layer (105A), the GaN insertion layer (106A), and the second AlGaN barrier sub-layer (105B) are sequentially and successively provided on the Si<111> substrate (101) without any intermediate layers, wherein the first AlGaN barrier sub-layer (105A), the GaN insertion layer (106A), and the second AlGaN barrier sub-layer (105B) forms a barrier layer; a Two-dimensional Electron Gas, 2DEG, is formed between the unintentional doped GaN channel layer (104) and the first AlGaN barrier sub-layer (105A) of the barrier layer; the barrier layer is at least provided with a first source area, a second source area, a first gate area, a second gate area, a first drain area, and a second drain area, wherein the first source area, the second source area, the first drain area, and the second drain area are respectively provided with a first source contact metal (109A), a second source contact metal (109B), a first drain contact metal (110A) and a second drain contact metal (110B) which are made of a Ti/Al/Ti/Au multilayer structure; wherein a first P-type GaN gate (107A) is provided in a groove structure formed in the first gate area, such that the first P-type GaN gate (107A) fills the groove structure and has a T-shape with portions provided on an upper surface of the second AlGaN barrier sub-layer (105B), the groove structure penetrates through the second AlGaN barrier sub-layer (105B) and the GaN insertion layer (106A) and ends at an upper surface of the first AlGaN barrier sub-layer (105A), and a second P-type GaN gate (107B) is provided in the second gate area, such that a lowermost surface of the second P-type GaN gate (107B) is provided on the upper surface of the second AlGaN barrier sub-layer (105B), wherein an uppermost surface of each of the first P-type GaN gate (107A) and the second P-type GaN gate (107B) is 80 nm above the upper surface of the second AlGaN barrier sub-layer (105B), and the first P-type GaN gate (107A) and the second P-type GaN gate (107B) each have an Mg doping concentration of 2-5 × 10¹⁹/cm³; wherein a first Schottky gate contact metal (108A) with a Ti/Au bilayer structure is provided on the first P-type GaN gate (107A), and a second Schottky gate contact metal (108B) with a Ti/Au bilayer structure is provided on the second P-type GaN gate (107B); wherein the first source area, the first gate area, and the first drain area cooperate with each other to form a first enhanced-mode HEMT unit, and the first enhanced-mode HEMT unit has a first threshold voltage; the second source area, the second gate area, and the second drain area cooperate with each other to form a second enhanced-mode HEMT unit, and the second enhanced-mode HEMT unit has a second threshold voltage; and a thickness of the barrier layer in the first gate area is less than a thickness of the barrier layer in the second gate area to enable the first threshold voltage to be higher than the second threshold voltage.

2. A method for preparing a GaN-based High Electron Mobility Transistor, HEMT, structure having a multi-threshold voltage, comprising:
a first step, S1:
sequentially and successively growing on a Si<111> substrate (101), by using Metal-Organic Chemical Vapour Deposition, MOCVD, an AlN/AlGaN transition layer (102) with a thickness of 300 nm, a C-doped Al_{0.07}Ga_{0.93}N high resistance layer (103) with a thickness of 4 µm, an unintentional doped GaN channel layer (104) with a thickness of 150 nm, a first AlGaN barrier sub-layer (105A) with a thickness of 12 nm, a GaN insertion layer (106A) with a thickness of 4 nm, and a second AlGaN barrier sub-layer (105B) with a thickness of 4 nm without any intermediate layers, wherein the first AlGaN barrier sub-layer (105A), the GaN insertion layer (106A), and the second AlGaN barrier sub-layer (105B) form a barrier layer; at least defining a first source area, a second source area, a first gate area, a second gate area, a first drain area, and a second drain area on the barrier layer;
a second step, S2:
using photoresist as a mask; after performing photoetching patterning, removing the first gate area of the second AlGaN barrier sub-layer (105B) and a part of the GaN insertion layer (106A) by using an Inductively Coupled Plasma, ICP, etching method in a thickness direction to form a groove structure, performing a wet surface treatment and MOCVD high temperature thermal decomposition treatment, such that after the wet surface treatment and MOCVD high temperature thermal decomposition treatment, the groove structure ends at an upper surface of the first AlGaN barrier sub-layer (105A); and performing an epitaxial growth of a p-type GaN layer with an Mg doping concentration of 2-5 × 10¹⁹/cm³;
a third step, S3:
using photoresist as a mask; after performing photoetching patterning, removing the p-type GaN layer in a non-gate area by using a dry etching method, and stopping the dry etching at an upper surface of the second AlGaN barrier sub-layer (105B), so as forming a first P-type GaN gate (107A) in the groove structure and a second P-type GaN gate (107B) on the upper surface of the second AlGaN barrier sub-layer (105B), such that the first P-type GaN gate (107A) fills the groove structure and has a T-shape with portions provided on the upper surface of the second AlGaN barrier sub-layer (105B), and a lowermost surface of the second P-type GaN gate (107B) is provided on the upper surface of the second AlGaN barrier sub-layer (105B), wherein an uppermost surface of each of the first P-type GaN gate (107A) and the second P-type GaN gate (107B) is 80 nm above the upper surface of the second AlGaN barrier sub-layer (105B);
a fourth step, S4:
removing the photoresist by using an organic cleaning method, performing hydrofluoric acid, HF, treatment to remove an oxide layer on the surface of the barrier layer, and performing rapid annealing at 500°C in an N₂ atmosphere to recover a two-dimensional electron gas, 2DEG, at a heterojunction between the unintentional doped GaN channel layer (104) and the first AlGaN barrier sub-layer (105A) of the barrier layer; depositing Ti/Au on the first P-type GaN gate (107A) and the second P-type GaN gate (107B) to form a first Schottky gate contact metal (108A) and a second Schottky gate contact metal (108B), respectively; depositing Ti/Al/Ti/Au in each of the first source area, the second source area, the first drain area, and the second drain area of the barrier layer to form a first source contact metal (109A), a second source contact metal (109B), a first drain contact metal (110A), and a second drain contact metal (110B), respectively;
wherein the first source area, the first gate area, and the first drain area cooperate with each other to form a first enhanced-mode HEMT unit, the second source area, the second gate area, and the second drain area cooperate with each other to form a second enhanced-mode HEMT unit, the first enhanced-mode HEMT unit has a first threshold voltage, and the second enhanced-mode HEMT unit has a second threshold voltage; and
wherein a thickness of the barrier layer in the first gate area is less than a thickness of the barrier layer in the second gate area to enable the first threshold voltage to be higher than the second threshold voltage.

## Patentansprüche

1. Eine GaN-basierte High Electron Mobility Transistor-Struktur, HEMT-Struktur, mit einer Mehrfach-Schwellspannung, umfassend ein Si<111>-Substrat (101), eine AlN/AlGaN-Übergangsschicht (102) mit einer Dicke von 300 nm, eine C-dotierte Al_{0.07}Ga_{0.93}N -Hochwiderstandsschicht (103) mit einer Dicke von 4 µm, eine unbeabsichtigt dotierte GaN-Kanalschicht (104) mit einer Dicke von 150 nm, eine erste AlGaN-Barrieresubschicht (105A) mit einer Dicke von 12 nm, eine GaN-Einfügungsschicht (106A) mit einer Dicke von 4 nm und eine zweite AlGaN-Barrieresubschicht (105B) mit einer Dicke von 4 nm, wobei die AlN/AlGaN-Übergangsschicht (102), die C-dotierte Al_{0.07}Ga_{0.93}N-Hochwiderstandsschicht (103), die unbeabsichtigt dotierte GaN-Kanalschicht (104), die erste AlGaN-Barrieresubschicht (105A), die GaN-Einfügungsschicht (106A) und die zweite AlGaN-Barrieresubschicht (105B) sequentiell und nacheinander auf dem Si<111>Substrat (101) ohne irgendwelche Zwischenschichten vorgesehen sind, wobei die erste AlGaN-Barrieresubschicht (105A), die GaN-Einfügungsschicht (106A) und die zweite AlGaN-Barrieresubschicht (105B) eine Barriereschicht bilden; wobei ein zweidimensionales Elektronengas (2DEG) zwischen der unbeabsichtigt dotierten GaN-Kanalschicht (104) und der ersten AlGaN-Barrieresubschicht (105A) der Barriereschicht gebildet ist; wobei die Barriereschicht zumindest mit einem ersten Sourcebereich, einem zweiten Sourcebereich, einem ersten Gatebereich, einem zweiten Gatebereich, einem ersten Drainbereich und einem zweiten Drainbereich vorgesehen ist, wobei der erste Sourcebereich, der zweite Sourcebereich, der erste Drainbereich und der zweite Drainbereich jeweils mit einem ersten Sourcekontaktmetall (109A), einem zweiten Sourcekontaktmetall (109B), einem ersten Drainkontaktmetall (110A) und einem zweiten Drainkontaktmetall (110B) vorgesehen sind, die aus einer Ti/Al/Ti/Au-Mehrschichtstruktur hergestellt sind; wobei ein erstes p-Typ-GaN-Gate (107A) in einer im ersten Gatebereich gebildeten Grabenstruktur vorgesehen ist, so dass das erste p-Typ-GaN-Gate (107A) die Grabenstruktur ausfüllt und eine T-Form mit Abschnitten aufweist, die auf einer oberen Oberfläche der zweiten AlGaN-Barrieresubschicht (105B) vorgesehen sind, wobei die Grabenstruktur die zweite AlGaN-Barrieresubschicht (105B) und die GaN-Einfügungsschicht (106A) durchdringt und an einer oberen Oberfläche der ersten AlGaN-Barrieresubschicht (105A) endet, und ein zweites p-Typ-GaN-Gate (107B) im zweiten Gatebereich vorgesehen ist, so dass eine unterste Oberfläche des zweiten p-Typ-GaN-Gates (107B) auf der oberen Oberfläche der zweiten AlGaN-Barrieresubschicht (105B) vorgesehen ist, wobei eine oberste Oberfläche jedes des ersten p-Typ-GaN-Gates (107A) und des zweiten p-Typ-GaN-Gates (107B) 80 nm oberhalb der oberen Oberfläche der zweiten AlGaN-Barrieresubschicht (105B) liegt, und das erste p-Typ-GaN-Gate (107A) und das zweite p-Typ-GaN-Gate (107B) jeweils eine Mg-Dotierkonzentration von 2-5 × 10¹⁹/cm³ aufweisen; wobei ein erstes Schottky-Gatekontaktmetall (108A) mit einer Ti/Au-Doppelschichtstruktur auf dem ersten p-Typ-GaN-Gate (107A) vorgesehen ist, und ein zweites Schottky-Gatekontaktmetall (108B) mit einer Ti/Au-Doppelschichtstruktur auf dem zweiten p-Typ-GaN-Gate (107B) vorgesehen ist; wobei der erste Sourcebereich, der erste Gatebereich und der erste Drainbereich miteinander zusammenwirken, um eine erste Enhanced-Mode-HEMT-Einheit zu bilden, und die erste Enhanced-Mode-HEMT-Einheit eine erste Schwellspannung aufweist; der zweite Sourcebereich, der zweite Gatebereich und der zweite Drainbereich miteinander zusammenwirken, um eine zweite Enhanced-Mode-HEMT-Einheit zu bilden, und die zweite Enhanced-Mode-HEMT-Einheit eine zweite Schwellspannung aufweist; und wobei eine Dicke der Barriereschicht im ersten Gatebereich geringer ist als eine Dicke der Barriereschicht im zweiten Gatebereich, so dass die erste Schwellspannung höher ist als die zweite Schwellspannung.

2. Ein Verfahren zum Herstellen einer GaN-basierten High Electron Mobility Transistor-Struktur, HEMT-Struktur, mit einer Mehrfach-Schwellspannung, umfassend:
einen ersten Schritt, S1:
sequentielles und aufeinanderfolgendes Aufwachsen auf einem Si<111>-Substrat (101) unter Verwendung von Metal-Organic Chemical Vapour Deposition (MOCVD) einer AlN/AlGaN-Übergangsschicht (102) mit einer Dicke von 300 nm, einer C-dotierten Al_{0.07}Ga_{0.93}N-Hochwiderstandsschicht (103) mit einer Dicke von 4 µm, einer unbeabsichtigt dotierten GaN-Kanalschicht (104) mit einer Dicke von 150 nm, einer ersten AlGaN-Barrieresubschicht (105A) mit einer Dicke von 12 nm, einer GaN-Einfügungsschicht (106A) mit einer Dicke von 4 nm und einer zweiten AlGaN-Barrieresubschicht (105B) mit einer Dicke von 4 nm ohne irgendwelche Zwischenschichten, wobei die erste AlGaN-Barrieresubschicht (105A), die GaN-Einfügungsschicht (106A) und die zweite AlGaN-Barrieresubschicht (105B) eine Barriereschicht bilden; und zumindest ein erster Sourcebereich, ein zweiter Sourcebereich, ein erster Gatebereich, ein zweiter Gatebereich, ein erster Drainbereich und ein zweiter Drainbereich auf der Barriereschicht definiert werden;
einen zweiten Schritt, S2:
Verwenden von Fotolack als Maske; nach Durchführung einer Fotolithographie-Strukturierung Entfernen des ersten Gatebereichs der zweiten AlGaN-Barrieresubschicht (105B) und eines Teils der GaN-Einfügungsschicht (106A) unter Verwendung eines Inductively Coupled Plasma (ICP)-Ätzverfahrens in einer Dickenrichtung, um eine Grabenstruktur zu bilden, Durchführen einer nassen Oberflächenbehandlung und einer MOCVD-Hochtemperatur-Thermozersetzungsbehandlung, so dass nach der nassen Oberflächenbehandlung und der MOCVD-Hochtemperatur-Thermozersetzungsbehandlung die Grabenstruktur an einer oberen Oberfläche der ersten AlGaN-Barrieresubschicht (105A) endet; und Durchführen eines epitaktischen Wachstums einer p-Typ-GaN-Schicht mit einer Mg-Dotierkonzentration von 2-5 × 10¹⁹/cm³;
einen dritten Schritt, S3:
Verwenden von Fotolack als Maske; nach Durchführung einer Fotolithographie-Strukturierung Entfernen der p-Typ-GaN-Schicht in einem Nicht-Gatebereich unter Verwendung eines Trockenätzverfahrens und Stoppen des Trockenätzens an einer oberen Oberfläche der zweiten AlGaN-Barrieresubschicht (105B), um ein erstes p-Typ-GaN-Gate (107A) in der Grabenstruktur und ein zweites p-Typ-GaN-Gate (107B) auf der oberen Oberfläche der zweiten AlGaN-Barrieresubschicht (105B) zu bilden, so dass das erste p-Typ-GaN-Gate (107A) die Grabenstruktur ausfüllt und eine T-Form mit Abschnitten aufweist, die auf der oberen Oberfläche der zweiten AlGaN-Barrieresubschicht (105B) vorgesehen sind, und eine unterste Oberfläche des zweiten p-Typ-GaN-Gates (107B) auf der oberen Oberfläche der zweiten AlGaN-Barrieresubschicht (105B) vorgesehen ist, wobei eine oberste Oberfläche jedes des ersten p-Typ-GaN-Gates (107A) und des zweiten p-Typ-GaN-Gates (107B) 80 nm oberhalb der oberen Oberfläche der zweiten AlGaN-Barrieresubschicht (105B) liegt;
einen vierten Schritt, S4:
Entfernen des Fotolacks unter Verwendung eines organischen Reinigungsverfahrens, Durchführen einer Fluorwasserstoffsäure (HF)-Behandlung zum Entfernen einer Oxidschicht auf der Oberfläche der Barriereschicht und Durchführen eines Schnellglühens bei 500 °C in einer N₂-Atmosphäre zum Wiederherstellen eines zweidimensionalen Elektronengases (2DEG) an einer Heteroübergangsschnittstelle zwischen der unbeabsichtigt dotierten GaN-Kanalschicht (104) und der ersten AlGaN-Barrieresubschicht (105A) der Barriereschicht; Abscheiden von Ti/Au auf dem ersten p-Typ-GaN-Gate (107A) und dem zweiten p-Typ-GaN-Gate (107B), um jeweils ein erstes Schottky-Gatekontaktmetall (108A) und ein zweites Schottky-Gatekontaktmetall (108B) zu bilden; Abscheiden von Ti/Al/Ti/Au in jedem des ersten Sourcebereichs, des zweiten Sourcebereichs, des ersten Drainbereichs und des zweiten Drainbereichs der Barriereschicht, um jeweils ein erstes Sourcekontaktmetall (109A), ein zweites Sourcekontaktmetall (109B), ein erstes Drainkontaktmetall (110A) und ein zweites Drainkontaktmetall (110B) zu bilden;
wobei der erste Sourcebereich, der erste Gatebereich und der erste Drainbereich miteinander zusammenwirken, um eine erste Enhanced-Mode-HEMT-Einheit zu bilden, der zweite Sourcebereich, der zweite Gatebereich und der zweite Drainbereich miteinander zusammenwirken, um eine zweite Enhanced-Mode-HEMT-Einheit zu bilden, wobei die erste Enhanced-Mode-HEMT-Einheit eine erste Schwellspannung aufweist und die zweite Enhanced-Mode-HEMT-Einheit eine zweite Schwellspannung aufweist; und
wobei eine Dicke der Barriereschicht im ersten Gatebereich geringer ist als eine Dicke der Barriereschicht im zweiten Gatebereich, so dass die erste Schwellspannung höher ist als die zweite Schwellspannung.

## Revendications

1. Structure de transistor à haute mobilité électronique (HEMT) à base de GaN ayant de multiples tensions seuil, comprenant un substrat en Si<111> (101), une couche de transition en AlN/AlGaN (102) avec une épaisseur de 300 nm, une couche à résistance élevée en Al_{0.07}Ga_{0.93}N dopé au C (103) avec une épaisseur de 4 µm, une couche canal en GaN dopé inintentionnellement (104) avec une épaisseur de 150 nm, une première sous-couche barrière en AlGaN (105A) avec une épaisseur de 12 nm, une couche d'insertion en GaN (106A) avec une épaisseur de 4 nm, et une deuxième sous-couche barrière en AlGaN (105B) avec une épaisseur de 4 nm, dans laquelle la couche de transition en AlN/AlGaN (102), la couche à résistance élevée en Al_{0.07}Ga_{0.93}N dopé au C (103), la couche canal en GaN dopé inintentionnellement (104), la première sous-couche barrière en AlGaN (105A), la couche d'insertion en GaN (106A), et la deuxième sous-couche barrière en AlGaN (105B) sont ménagées en séquence et de manière successive sur le substrat en Si<111> (101) sans aucunes couches intermédiaires, dans laquelle la première sous-couche barrière en AlGaN (105A), la couche d'insertion en GaN (106A), et la deuxième sous-couche barrière en AlGaN (105B) forment une couche barrière ; un gaz bidimensionnel d'électrons, 2DEG, est formé entre la couche canal en GaN dopé inintentionnellement (104) et la première sous-couche barrière en AlGaN (105A) de la couche barrière ; la couche barrière est pourvue au moins d'une première zone de source, d'une deuxième zone de source, d'une première zone de grille, d'une deuxième zone de grille, d'une première zone de drain, et d'une deuxième zone de drain, dans laquelle la première zone de source, la deuxième zone de source, la première zone de drain, et la deuxième zone de drain sont respectivement pourvues d'un premier contact métallique de source (109A), d'un deuxième contact métallique de source (109B), d'un premier contact métallique de drain (110A) et d'un deuxième contact métallique de drain (110B) qui sont réalisés d'une structure multicouche en Ti/Al/Ti/Au ; dans laquelle une première grille en GaN de type P (107A) est ménagée dans une structure en rainure formée dans la première zone de grille, de telle sorte que la première grille en GaN de type P (107A) remplisse la structure en rainure et présente une forme en T avec des parties ménagées sur une surface supérieure de la deuxième sous-couche barrière en AlGaN (105B), la structure en rainure pénètre à travers la deuxième sous-couche barrière en AlGaN (105B) et la couche d'insertion en GaN (106A) et se termine au niveau d'une surface supérieure de la première sous-couche barrière en AlGaN (105A), et une deuxième grille en GaN de type P (107B) est ménagée dans la deuxième zone de grille, de telle sorte qu'une surface la plus basse de la deuxième grille en GaN de type P (107B) est ménagée sur la surface supérieure de la deuxième sous-couche barrière en AlGaN (105B), dans laquelle une surface la plus élevée de chacune de la première grille en GaN de type P (107A) et de la deuxième grille en GaN de type P (107B) est 80 nm au-dessus de la surface supérieure de la deuxième sous-couche barrière en AlGaN (105B), et chacune de la première grille en GaN de type P (107A) et de la deuxième grille en GaN de type P (107B) présente une concentration de dopage de Mg de 2-5 × 10¹⁹/cm³ ; dans laquelle un premier contact métallique de grille Schottky (108A) avec une structure bicouche en Ti/Au est ménagé sur la première grille en GaN de type P (107A), et un deuxième contact métallique de grille Schottky (108B) avec une structure bicouche en Ti/Au est ménagé sur la deuxième grille en GaN de type P (107B) ; dans laquelle la première zone de source, la première zone de grille, et la première zone de drain coopèrent l'une avec l'autre pour former une première unité HEMT à enrichissement, et la première unité HEMT à enrichissement présente une première tension seuil ; la deuxième zone de source, la deuxième zone de grille et la deuxième zone de drain coopèrent l'une avec l'autre pour former une deuxième unité HEMT à enrichissement, et la deuxième unité HEMT à enrichissement présente une deuxième tension seuil ; et une épaisseur de la couche barrière dans la première zone de grille est plus petite qu'une épaisseur de la couche barrière dans la deuxième zone de grille pour permettre à la première tension seuil d'être supérieure à la deuxième tension seuil.

2. Procédé de préparation d'une structure de transistor à haute mobilité électronique (HEMT) à base de GaN, ayant de multiples tensions seuil, comprenant :
une première étape, S1 :
faire croître sur un substrat en Si<111> (101), en séquence et de manière successive, à l'aide d'un dépôt chimique en phase vapeur à partir de précurseurs organométalliques, MOCVD, une couche de transition en AlN/AlGaN (102) avec une épaisseur de 300 nm, une couche à résistance élevée en Al_{0.07}Ga_{0.93}N dopé au C (103) avec une épaisseur de 4 µm, une couche canal en GaN dopé inintentionnellement (104) avec une épaisseur de 150 nm, une première sous-couche barrière en AlGaN (105A) avec une épaisseur de 12 nm, une couche d'insertion en GaN (106A) avec une épaisseur de 4 nm, et une deuxième sous-couche barrière en AlGaN (105B) avec une épaisseur de 4 nm sans aucunes couches intermédiaires, dans lequel la première sous-couche barrière en AlGaN (105A), la couche d'insertion en GaN (106A), et la deuxième sous-couche barrière en AlGaN (105B) forment une couche barrière ; définissant au moins une première zone de source, une deuxième zone de source, une première zone de grille, une deuxième zone de grille, une première zone de drain, et une deuxième zone de drain sur la couche barrière ;
une deuxième étape, S2 :
utiliser une résine photosensible en tant que masque ; après la réalisation d'une structuration en motifs par photogravure, retirer la première zone de grille de la deuxième sous-couche barrière en AlGaN (105B) et une partie de la couche d'insertion en GaN (106A) à l'aide d'un plasma à couplage inductif, ICP, un procédé de gravure dans une direction d'épaisseur pour former une structure en rainure, effectuer un traitement de surface humide et un traitement de décomposition thermique à haute température MOCVD, de telle sorte qu'après le traitement de surface humide et le traitement de décomposition thermique à haute température MOCVD, la structure en rainure se termine au niveau d'une surface supérieure de la première sous-couche barrière en AlGaN (105A) ; et effectuer une croissance par épitaxie d'une couche en GaN de type p avec une concentration de dopage au Mg de 2-5 × 10¹⁹/cm³ ;
une troisième étape, S3 :
utiliser une résine photosensible en tant que masque ; après la réalisation d'une structuration en motifs par photogravure, retirer la couche en GaN de type p dans une zone hors-grille à l'aide d'un procédé de gravure sèche, et stopper la gravure sèche au niveau d'une surface supérieure de la deuxième sous-couche barrière en AlGaN (105B), de façon à former une première grille en GaN de type P (107A) dans la structure en rainure et une deuxième grille en GaN de type P (107B) sur la surface supérieure de la deuxième sous-couche barrière en AlGaN (105B), de telle sorte que la première grille en GaN de type P (107A) remplisse la structure en rainure et présente une forme en T avec des parties ménagées sur la surface supérieure de la deuxième sous-couche barrière en AlGaN (105B), et une surface la plus basse de la deuxième grille en GaN de type P (107B) est ménagée sur la surface supérieure de la deuxième sous-couche barrière en AlGaN (105B), dans lequel une surface la plus élevée de chacune de la première grille en GaN de type P (107A) et de la deuxième grille en GaN de type P (107B) est 80 nm au-dessus de la surface supérieure de la deuxième sous-couche barrière en AlGaN (105B) ;
une quatrième étape, S4 :
retirer la résine photosensible à l'aide d'un procédé de nettoyage organique, effectuer un traitement à l'acide fluorhydrique, HF, pour retirer une couche d'oxyde sur la surface de la couche barrière, et effectuer un recuit rapide à 500°C dans une atmosphère de N₂ pour récupérer un gaz bidimensionnel d'électrons, 2DEG, au niveau d'une hétérojonction entre la couche canal en GaN inintentionnellement dopé (104) et la première sous-couche barrière en AlGaN (105A) de la couche barrière ; déposer du Ti/Au sur la première grille en GaN de type P (107A) et la deuxième grille en GaN de type P (107B) pour former un premier contact métallique de grille Schottky (108A) et un deuxième contact métallique de grille Schottky (108B), respectivement ; déposer du Ti/Al/Ti/Au dans chacune de la première zone de source, la deuxième zone de source, la première zone de drain, et la deuxième zone de drain de la couche barrière pour former un premier contact métallique de source (109A), un deuxième contact métallique de source (109B), un premier contact métallique de drain (110A), et un deuxième contact métallique de drain (110B), respectivement ;
dans lequel la première zone de source, la première zone de grille, et la première zone de drain coopèrent l'une avec l'autre pour former une première unité HEMT à enrichissement, la deuxième zone de source, la deuxième zone de grille, et la deuxième zone de drain coopèrent l'une avec l'autre pour former une deuxième unité HEMT à enrichissement, la première unité HEMT à enrichissement présente une première tension seuil, et la deuxième unité HEMT à enrichissement présente une deuxième tension seuil ; et
dans lequel une épaisseur de la couche barrière dans la première zone de grille est plus petite qu'une épaisseur de la couche barrière dans la deuxième zone de grille pour permettre à la première tension seuil d'être supérieure à la deuxième tension seuil.
